# EUROPÄISCHE PATENTSCHRIFT

(11) **EP 1 220 292 B1**
(45) Veröffentlichungstag und Bekanntmachung des Hinweises auf die Patenterteilung: **16.04.2008**
(21) Anmeldenummer: 01126990.9
(22) Anmeldetag: 14.11.2001
(51) Int. Cl.: H01J 49/46, H01J 49/28, H01J 37/05

(54) **Monochromator für geladene Teilchen**
Monochromator for charged particles
Monochromateur pour particules chargées

(30) Priorität: 12.12.2000 DE 10061798
(43) Veröffentlichungstag der Anmeldung: 03.07.2002
(73) Patentinhaber: Carl Zeiss NTS GmbH, 73447 Oberkochen (DE)
(72) Erfinder: Plies, Erich, 72074 Tübingen (DE); Huber, Armin, 72762 Reutlingen (DE); Bärtle, Jan, 72070 Tübingen (DE)
(74) Vertreter: Gnatzig, Klaus

(56) Entgegenhaltungen:
- WO-A-99/46797
- J. ANDERSON ET AL.: "a double wienfilter as a high resolution ,high transmission electron energy analyser" JOURNAL OF PHYSICS E SCIENTIFIC INSTRUMENTS, Nr. 3, 1970, Seiten 121-126, XP008041578
- M.TERAUCHI ET AL.: "high energy-resolution electron energy-loss spectroscopy based on electron microscopy" INSTITUTE OF PHYSICS CONFERENCES SYMPOSIUM 6, Nr. 165, 2000, Seiten 217-218, XP008041579
- M.TANAKA ET AL.: "an 0.2eV energy resolution analytical electron microscope" INSTITUTE OF PHYSICS CONFERENCES SYMPOSIUM 6, Nr. 165, 2000, Seiten 211-212, XP001202692
- X ET AL: "Aberration analysis of Wien filters and design of an electron energy-selective imaging system" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A363, Nr. 1, 1995, Seiten 254-260, XP004009654 ISSN: 0168-9002

## Beschreibung

Die vorliegende Erfindung betrifft einen Monochromator für geladene Teilchen.

In modernen Niederspannungs-Elektronen-Mikroskopen begrenzt besonders die chromatische Unschärfe, insbesondere der axiale Farbfehler erster Ordnung, die erzielbare Auflösung auf etwa 3nm für 1keV Elektronenenergie. Der Durchmesser d des Farbfehlerscheibchens in der Gausschen Bildebene eines Objektivs läßt sich dabei beschreiben als Produkt aus einer Farbfehlerkonstante CF, der Apertur α des Elektronenstrahles in der Gausschen Bildebene und der relativen Energiebreite δE/E des Elektronenstrahles.

Die Farbfehlerkonstante ist bei den eingesetzten rotations-symmetrischen Elektronenlinsen aufgrund des Scherzerschen Theorems prinzipiell ungleich null und die Elektronen sind aufgrund des Emissionsprozesses und des Boerscheffektes, also der anomalen Energieverbreiterung durch stochastische Coulombwechselwirkung, nicht monochromatisch, so daß die relative Energiebandbreite stets ungleich null ist. Für ein modernes Niederspannungsraster-Elektronenmikroskop mit optimierter Objektivlinse und einem Zirkoniumoxid-Wolfram-Schottky-Emitter als Elektronenquelle beträgt die Farbfehlerkonstante etwa 1,5mm für Elektronen mit einer Energie von 1keV und bei einem Arbeitsabstand von 2mm. Die Energiebreite δE beträgt etwa 0,5 bis 1eV abhängig vom Strahlstrom.

Da eine weitere Minimierung der Farbfehlerkonstante kaum möglich ist, ist es zur weiteren Steigerung der Auflösung bereits bekannt, Farbfehlerkorrektoren, die entweder aus Quadrupol-Linsensystemen oder elektrostatischen Spiegeln bestehen, einzusetzen. Als Alternative zu den bezüglich ihres Aufbaus in der Regel sehr komplexen Farbfehlerkorrektoren bietet es sich an, mit Hilfe eines Monochromators die Energiebreite des durch das nachfolgende elektronen-optische Abbildungssystem verarbeiteten Elektronenstrahles zu reduzieren.

Als Monochromator mit relativ einfachem Aufbau sind rotationssymmetrische elektrostatische Filterlinsen bekannt, in denen durch ein gegen die Ausbreitungsrichtung der Teilchen gerichtetes elektrostatisches Feld diejenigen Teilchen herausgefiltert werden, deren kinetische Energie unter der durch die elektrostatische Potentialdifferenz definierten Energie liegen. Solche elektrostatischen Filterlinsen haben jedoch den Nachteil, daß der Richtstrahlwert des Elektronenstrahles stark verschlechtert wird.

Darüberhinaus sind bereits elektrostatische Monochromatoren mit gekrümmten optischen Achsen vorgeschlagen worden. Systeme mit gekrümmten optischen Achsen sind jedoch in der Regel schwierig zu justieren.

Darüberhinaus sind als Monochromatoren für geladene Teilchen Wienfilter bekannt, bei denen ein elektrostatisches Dipolfeld und ein magnetisches Dipolfeld senkrecht zueinander überlagert angeordnet sind. Aus dem Aufsatz Journal of Physics E: Scientifique Instruments, Volume 3 (1970), Seiten 121 ff. ist es bereits bekannt, zwei hintereinander angeordnete Wienfilter einzusetzen, wobei die durchstrahlte Probe zwischen den beiden Wienfiltern angeordnet ist. Das zweite Wienfilter dient dabei als Energieanalysator zur Erzeugung des Elektronen-Energieverlustspektrums der Probe. Um die fokussierende Wirkung des Wienfilters in einer Richtung, nämlich in der Richtung des elektrostatischen Feldes, zu kompensieren, sind dabei die Wienfilter zwischen zwei Quadrupollinsen angeordnet.

Aus einem jüngeren Konferenzbeitrag von Tanaka et al., veröffentlicht im Institute of Physics Conferences Serienummer 165, Symposium 6, Seiten 217 - 218, ist ein weiterer Monochromator vorgeschlagen worden, der aus zwei hintereinander geschalteten Wienfiltern besteht. Die Energieselektion findet dabei in der Mitte zwischen den beiden Wienfiltern statt. Das zweite Wienfilter dient dabei dazu, die durch das erste Wienfilter erzeugte astigmatische Abbildung wieder aufzuheben.

In einem weiteren Konferenzbeitrag der selben Autoren auf der selben Konferenz (veröffentlicht in dem o.g. Band, Seiten 211 und 212) ist weiterhin der Aufbau eines Wienfilters beschrieben, bei dem die Oberflächen sowohl der elektrostatischen Elektroden als auch die Oberflächen der Polschuhe des magnetischen Dipoles als Zylinderflächen ausgebildet sind, so daß eine Einhaltung der Wienbedingung auch in größerem Abstand von der optischen Achse gewährleistet ist.

Ziel der vorliegenden Erfindung ist es, einen Monochromator mit einem einfachen Aufbau vorzuschlagen, der einfach zu justieren ist und keinen nachteiligen Einfluß auf den Richtstrahlwert des gefilterten Teilchenstrahles aufweist.

Dieses Ziel wird erfindungsgemäß durch einen Monochromator mit den Merkmalen der Ansprüche 1 oder 8 gelöst. Vorteilhafte Ausführungsbeispiele der Erfindung ergeben sich aus den Merkmalen der abhängigen Ansprüche.

Gemäß eines ersten Aspektes der Erfindung weist der Monochromator mehrere, vorzugsweise vier seriell hintereinander geschaltete Wienfilter auf, von denen ein Teil azimutal um betragsmäßig 90° um die optische Achse gegenüber den anderen Wienfiltern verdreht sind. Durch die gegeneinander verdrehte Anordnung der Wienfilter wird erreicht, daß ein Teil der Wienfilter, vorzugsweise die beiden äußeren, eine astigmatische Abbildung in einer Richtung und die anderen Wienfilter, vorzugsweise die mittleren, eine astigmatische Abbildung in der dazu senkrechten Richtung erzeugen, so daß insgesamt eine stigmatische Abbildung erreicht wird. Da gemäß dieses ersten Aspektes der Erfindung der Monochromator selbst stigmatisch abbilden kann, sind für eine stigmatische Abbildung keine weiteren Elemente, insbesondere keine zusätzlichen Quadrupole erforderlich.

Die Felder in den äußeren Wienfiltern sollten dabei parallel zueinander ausgerichtet sein und die Felder in den mittleren Wienfiltern anti-parallel zueinander ausgerichtet sein. Zusätzlich sollten die Brechkräfte der einzelnen Wienfilter so gewählt sein, daß eine der beiden axialen Fundamentalbahnen des Monochromators symmetrisch zur Mittelebene des Monochromators ist und die axiale Fundamentalbahn in der dazu senkrechten Schnittebene antisymmetrisch zur Mittelebene des Monochromators ist. Dadurch wird erreicht, daß die durch den Monochromator erzeugte Abbildung insgesamt auch dispersionsfrei ist; Energieschwankungen führen dann zu keiner zeitlichen Bewegung des Bildes.

In der Mitte des Monochromators wird ein astigmatisches Zwischenbild erzeugt, in dem die Energiefilterung durch eine Spaltblende erfolgen kann.

Um eine insgesamt stigmatische Abbildung zu erzeugen, sollte die Brechkraft der äußeren Wienfilter stärker als die Brechkraft der inneren Wienfilter gewählt sein.

Gemäß eines zweiten Aspektes der Erfindung mit einem oder mehreren seriell hintereinander in Ausbreitungsrichtung angeordneten Wienfiltern sind die Polschuhe der magnetischen Dipole des/der Wienfilter(s) und die Elektroden der elektrischen Dipole des/der Wienfilter(s) bezüglich einer Azimutaldrehung um 90° um die gemeinsame optische Achse symmetrisch zueinander ausgebildet. Dazu sollten die Elektroden der elektrischen Dipole aus dem selben weich-magnetischen Material bestehen wie die Polschuhe der magnetischen Dipole. Durch den symmetrischen Aufbau der magnetischen Dipole und der elektrischen Dipole zueinander wird erreicht, daß die magnetische und die elektrostatische Potentialverteilung und auch die magnetische und die elektrostatische Feldverteilung sowohl in jeweiliger Longitudinalrichtung als auch in der jeweiligen Transversalrichtung gleich sind.

Die Symmetrie von magnetischen und elektrostatischen Dipolfeldern auch in den Randbereichen führt einerseits dazu, daß Abbildungsfehler vermieden werden. Gleichzeitig liefert der symmetrische Aufbau des elektrostatischen Teils und des magnetischen Teiles der einzelnen Wienfilter herstellungstechnische Vorteile bei der seriellen Anordnung mehrerer zueinander verdrehter Wienfilter. Denn die Elektroden und Polschuhteile aller miteinander zu kombinierenden Wienfilter können aus einem Materialblock gefertigt werden, der in einem ersten Bearbeitungsschritten mit einer zentralen Längsbohrung für den Durchtritt der Elektronenbahn und weiteren Längsbohrungen für die spätere Wiedermontage versehen wird. Erst in einem zweiten Schritt werden dann die Elektroden und Polschuhe aller miteinander zu kombinierender Wienfilter herausgearbeitet und erst in einem dritten Schritt wird der Materialblock senkrecht zu den im ersten Schritt erzeugten Bohrungen zerlegt. In einem darauffolgenden Schritt werden dann die Spulen und elektrischen Kontaktierungen angebracht und die Isolierungen zwischen den einzelnen Polschuhen. Mit Hilfe der im ersten Schritt erzeugten Montagebohrungen ist dann bei der späteren Wiedermontage die zueinander symmetrische Anordnung gewährleistet.

Für eine korrekte Einstellung der Wienbedingung auch in den Randbereichen der Wienfilter sollten die einander zugerichteten Flächen der Polschuhe und Elektroden als konzentrische Kugelflächenabschnitte oder koaxiale Zylinderflächenausschnitte ausgebildet sein. Die konzentrischen Kugelflächenabschnitte oder koaxialen Zylinderflächenabschnitte der einander zugerichteten Flächen der Polschuhe und Elektroden können jedoch auch durch eine Vielzahl jeweils ebener, polygonal angeordneter Flächen approximiert sein. Weiterhin sollten die einzelnen Polschuhe eines jeden Wienfilters gegeneinander elektrisch isoliert sein und zwischen den einzelnen Wienfiltern sollten Blenden aus einem Material hoher magnetischer Permeabilität angeordnet sein, um Übersprechen der Magnetfelder zwischen den Wienfiltern zu verhindern.

Nachfolgend werden Einzelheiten der Erfindung anhand der in den Figuren dargestellten Ausführungsbeispiele näher erläutert. Dabei zeigen:
- Figur 1: einen Schnitt durch einen Monochromator nach der Erfindung in einer zur optischen Achse senkrechten Ebene;
- Figur 2: einen Schnitt durch den Monochromator in Figur 1 entlang der Schnittebene II-II;
- Figuren 3a und 3b: schematische Darstellungen der Abbildungseigenschaften eines Monochromators in zwei zueinander senkrechten Schnittebenen und
- Figur 4: ein Diagramm der Fundamentalbahnen in einem Monochromator nach den Figuren 1 und 2.

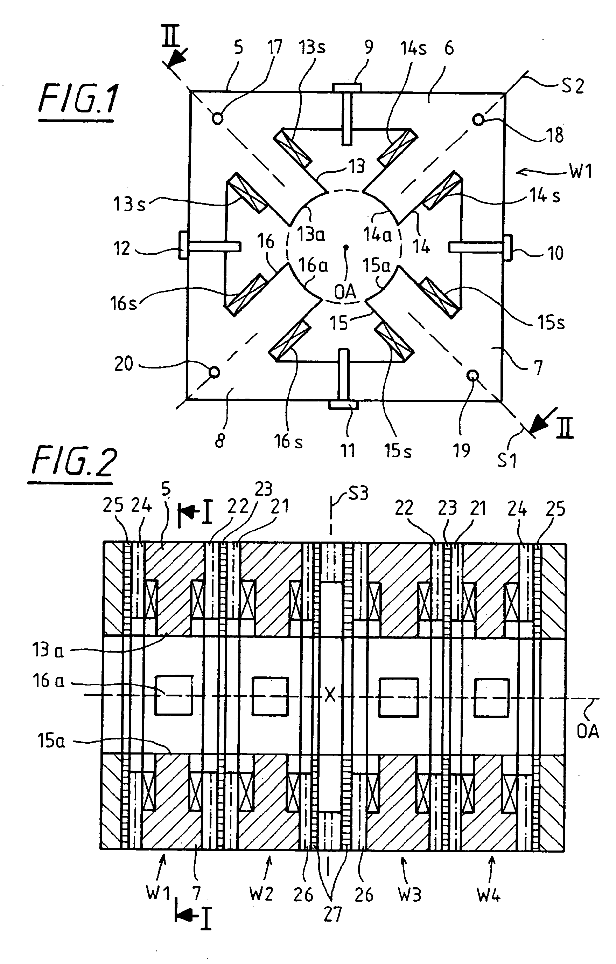

Wie den Figuren 1 und 2 zu entnehmen ist, besteht der erfindungsgemäße Monochromator aus insgesamt 4 Wienfiltern (W1, W2, W3, W4), die seriell entlang einer gemeinsamen optischen Achse (OA) angeordnet sind. Jedes der Wienfilter ist bezüglich einer Drehung um 90° um die optische Achse (OA) symmetrisch aufgebaut, d.h., jedes der Wienfilter (W1, W2, W3, W4) ist bezüglich zweier zueinander senkrechter Ebenen (S1, S2) symmetrisch. Jedes Wienfilter besteht aus vier Polschuhsegmenten (5, 6, 7, 8), die jeweils gegeneinander durch Isolatoren (9, 10, 11, 12) elektrisch isoliert sind. Jedes der vier Polschuhsegmente (5, 6, 7, 8) weist einen in Richtung der optischen Achse (OA) hinlaufenden Polschuh (13, 14, 15, 16) auf. Die der optischen Achse (OA) zugewandten Endflächen (13a, 14a, 15a, 16a) aller vier Polschuhe sind als zur optischen Achse (OA) koaxiale Zylinderflächenabschnitte ausgebildet. Um jeden der Poleschuhe (13, 14, 15, 16) ist jeweils eine Magnetspule (13s, 14s, 15s, 16s) für die Erzeugung der magnetischen Dipolfelder gelegt.

An dieser Stelle sei angemerkt, daß der Gesamtaufbau jedes einzelnen Wienfilters aufgrund der 90° Symmetrie bezüglich einer Drehung um die optische Achse (OA) vom Aufbau her dem eines magnetischen Quadrupoles ähnelt. Im Unterschied zu einem magnetischen Quadrupol werden jedoch bei den Wienfiltern bei einem Monochromator nach der Erfindung keine Quadrupolfelder erzeugt sondern reine Dipolfelder. Demzufolge werden jeweils die Spulen (13s, 15s) bzw. (14s, 16s) gegenüberliegender Polschuhe (13, 15) bzw. (14, 16) entgegengesetzt erregt, so daß die einander gegenüberliegenden Polschuhendflächen (13a, 15a) bzw. (14a, 16a) die magnetischen Nord- und Südpole bilden. Wird das Wienfilter so betrieben, daß beispielsweise die beiden gegenüberliegenden Polschuhe (13, 15) die magnetischen Nord- und Südpole bilden, bilden die beiden dazu um 90° verdreht angeordneten Polschuhe (14, 16) die Elektroden für die elektrischen Dipole. Dazu werden die Polschuhsegmente (6,8) mit denen diese beiden, die Elektroden bildenden Polschuhe (14, 16) verbunden sind, über nicht im einzelnen dargestellte Kontaktierungen mit geeigneten elektrischen Potentialen beaufschlagt. Die Spulen (14s, 16s), die um diejenigen Polschuhe (14, 16) gelegt sind, die die Elektroden des elektrostatischen Dipoles bildend, werden bei dieser Betriebsart eigentlich nicht benötigt. Sie liefern jedoch die Möglichkeit, bei Bedarf das Wienfilter um 90° bezüglich der optischen Achse (OA) verdreht zu betreiben, so daß sämtliche vier Wienfilter (W1, W2, W3, W4) einen identischen Aufbau aufweisen können und lediglich hinsichtlich der elektrischen und magnetischen Kontaktierungen unterschiedlich angesteuert werden.

In der Figur 1 weiterhin eingezeichnet sind die Bohrungen (17, 18, 19, 20), die für einen zentrierten Zusammenbau der seriellen Anordnung mehrerer Wienfilter vorgesehen sind.

Wie der Figur 2 zu entnehmen ist, sind die insgesamt vier Wienfilter (W1, W2, W3, W4) in Richtung der optischen Achse bezüglich ihres mechanischen Aufbaues symmetrisch zur Mittelebene (S3) angeordnet. Jeweils benachbarte Wienfilter (W1, W2) bzw. (W3, W4) sind gegeneinander jeweils durch eine Abfolge eines elektrischen Isolators (21), einer elektrisch leitfähigen Abschirmplatte (23) und eines weiteren Isolators (22) gegeneinander abgegrenzt. Die Abschrirmplatten (23) verhindern dabei sowohl ein Übersprechen der magnetischen Dipolfelder als auch der elektrostatischen Dipolfelder von einem Wienfilter auf das benachbarte Wienfilter. Die elektrischen Isolierungen (21, 22) verhindern Kurzschlüsse. Die Abschirmplatten (23) bilden demzufolge Randfeldblenden und bestehen aus elektrisch leitendem, weichmagnetischem Material, also ferromagnetischem Material mit hoher Permeabilität, hoher Leitfähigkeit und geringer Remanenz. Die Permeabilität sollte dabei größer als 10000 sein. Geeignete Materialien sind z.B. die von der Fa. Vacuumschmelze unter den Bezeichnungen "Mumetall" und "Vacoperm" hergestellten und angebotenen Materialien. Die Abschirmplatten (23) verhindern dadurch Verdrehungseffekte zwischen den benachbarten Wienfiltern (W1, W2 und W3, W4). Bei Bedarf können hier auch doppelte Randfeldblenden vorgesehen sein, um eine höhere Abschirmwirkung zu erreichen.

Weitere elektrische Isolierungen (24) und magnetische Abschirmplatten (25) aus elektrisch leitendem, weichmagnetischem Material sind jeweils an den beiden äußeren Rändern des Monochromators vorgesehen, um den Monochromator insgesamt sowohl magnetisch als auch elektrisch gegenüber den übrigen Komponenten des Elektronenmikroskopes, in das der Monochromator zum Einbau vorgesehen ist, zu isolieren bzw. abzuschirmen.

Weitere elektrische und magnetische Abschirmungen (26, 27) sind zusätzlich zwischen den beiden mittleren Wienfiltern (W2, W3) vorgesehen. In der Mittelebene (S3) des Wienfilters entsteht das astigmatische Zwischenbild, so daß in dieser Ebene die Spaltblende für die Energieselektion einzusetzen ist.

Trotz ihres konstruktiv identischen Aufbaus in der zur optischen Achse senkrechten Schnittebene werden die vier Wienfilter (W1, W2, W3, W4) teilweise um betragsmäßig 90° um die optische Achse (OA) verdreht betrieben. Bilden beim ersten Wienfilter (W1) die in der Zeichenebene der Figur 2 liegenden Polschuhe (13a, 15a) die magnetischen Dipole und die oberhalb und unterhalb der Zeichenebene liegenden Polschuhe (16a, 14a) die elektrostatischen Dipole, so ist die Ansteuerung des auf das erste Wienfilter folgenden zweiten Wienfilters (W2) genau um 90° verdreht, d.h. beim zweiten Wienfilter (W2) bilden die in der Zeichenebene der Figur 2 liegenden Polschuhe die elektrostatischen Dipole und die vor und hinter der Zeichenebene der Figur 2 liegenden Polschuhe die magnetischen Dipole. Das auf die Mittelebene (S3) folgende Wienfilter (W3) wird exakt invers zu dem vorhergehenden Wienfilter (W2) betrieben, d.h. auch hier bilden die in der Zeichenebene der Figur 2 liegenden Polschuhe die Elektroden der elektrostatischen Dipole und die vor und hinter der Zeichenebene liegenden Polschuhe die magnetischen Dipole, jedoch mit inverser Polarität zu dem zweiten Wienfilter (W2). Das vierte Wienfilter (W4) wird dann wiederum identisch zu dem ersten Wienfilter (W1) betrieben.

Wie sich aus dem vorstehenden ergibt, sind die beiden mittleren Wienfilter (W2, W3) antisymmetrisch zueinander und die beiden äußeren Wienfilter (W1, W4) symmetrisch zueinander und die beiden inneren Wienfilter (W2, W3) jeweils um 90° bezüglich der optischen Achse (OA) gegenüber dem benachbarten äußeren Wienfilter (W1, W4) verdreht.

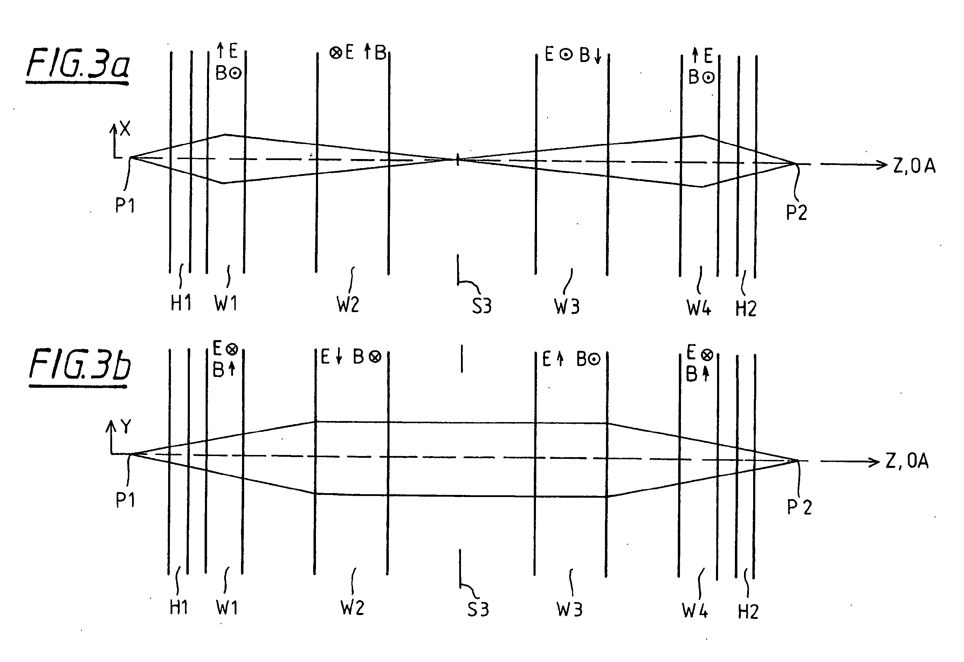

Die Abbildungseigenschaften des beschriebenen Wienfilters lassen sich am einfachsten anhand der Figuren 3a und 3b erläutern. In den Figuren 3a und 3b sind wiederum die vier Wienfilter (W1, W2, W3, W4) mit den Richtungen der jeweiligen elektrischen Felder (E) und der jeweiligen magnetischen Felder (B) angedeutet. In der Figur 3a sind dabei die von einem Punkt (P1) in einer ersten Schnittebene (XZ) ausgehenden Fundamentalbahnen dargestellt. Für Bahnverläufe in der XZ-Ebene fokussieren jeweils die beiden äußeren Wienfilter (W1, W4), wohingegen in dieser Schnittebene die beiden mittleren Wienfilter (W2, W3) keine abbildenden Eigenschaften aufweisen, da die Magnetfelder (B) der beiden mittleren Wienfilter (W2, W3) in der XZ-Ebene liegen und die elektrostatischen Felder (E) dieser beiden Wienfilter (W2, W3) senkrecht zu der XZ-Ebene liegen. Lediglich in den beiden äußeren Wienfiltern (W1, W4) bewirkt hingegen die Lorentzkraft und die elektrostatische Kraft eine Abbildung. Die Stärke der Felder in den beiden äußeren Wienfiltern (W1, W4) ist dabei in Abhängigkeit von der Elektronenenergie so gewählt, daß in der XZ-Ebene in der Mittelebene (S3) ein astigmatisches Zwischenbild entsteht. Aufgrund des symmetrischen Aufbaus des gesamten Monochromators bildet symmetrisch zum ersten Wienfilter (W1) das letzten Wienfilter (W4) das in der Mittelebene (S3) entstehende Zwischenbild in den hinter dem Monochromator liegenden Punkt (P2) ab; die Brechkraft des letzten Wienfilters (W4) ist dazu identisch zur Brechkraft des ersten Wienfilters (W1), weshalb das erste und letzte Wienfilter (W1, W4) zweckmäßig identische Längen in Richtung der optischen Achse (OA) haben.

In der Figur 3b sind die vom selben Punkt (P1) ausgehenden Strahlen in einer zur Figur 3a senkrechten Ebene, im YZ-Schnitt dargestellt. In dieser YZ-Schnittebene sind die beiden äußeren Wienfilter (W1, W4) wirkungslos, da die elektrostatischen Felder (E) senkrecht zu dieser Schnittebene und die Magnetfelder (B) in dieser Schnittebene liegen. In dieser Schnittebene (YZ) bewirken dem hingegen die beiden mittleren Wienfilter (W2, W3) aufgrund der Lorentzkraft und der ellektrostatischen Kraft eine Abbildung. Die Stärke der beiden mittleren Wienfilter (W2, W3) ist dabei in Abhängigkeit von der Teilchenenergie so gewählt, daß die vom Punkt (P1) ausgehenden Teilchenbahnen nach Austritt aus dem zweiten Wienfilter (W2), und damit im Bereich der Mittelebene (S3), parallel zur optischen Achse (OA) verlaufen und vom dritten Wienfilter (W3) in den selben Punkt (P2) fokussiert werden, in dem auch die Abbildung des Punktes (P1) im XZ-Schnitt erfolgt. Wie sich bereits aus den Abständen der beiden mittleren Wienfilter (W2, W3) relativ zu den Abständen der beiden äußeren Wienfilter (W1, W4) zu den beiden konjugierten Punkten (P1, P2) ergibt, ist die Brechkraft der beiden äußeren Wienfilter (W1, W4) stärker gewählt als die Brechkraft der beiden mittleren Wienfilter (W2, W3). Die Brechkräfte der beiden mittleren Wienfilter (W2, W3) sind dabei betragsmäßig gleich. Zweckmäßig sind demzufolge auch die Längen der beiden mittleren Wienfilter (W2, W3) in Richtung der optischen Achse identisch; sie können jedoch einegrößere Länge als die beiden äußeren Wienfilter (W1, W4) in Richtung der optischen Achse (OA) aufweisen.

Insgesamt bildet der Monochromator als Ganzes stigmatisch ab, d.h., der Punkt (P1) wird stigmatisch in den Punkt (P2) abgebildet. Die Vergrößerung im XZ-Schnitt ist dabei +1 und im YZ-Schnitt―1. Dieses wird beim erfindungsgemäßen Monochromator ohne zusätzliche Quadrupollinsen oder Quadrupolfeldanteile der einzelnen Wienfilter erreicht, d.h. jedes der Wienfilter (W1, W2, W3, W4) stellt ein sogenanntes homogenes Wienfilter dar.

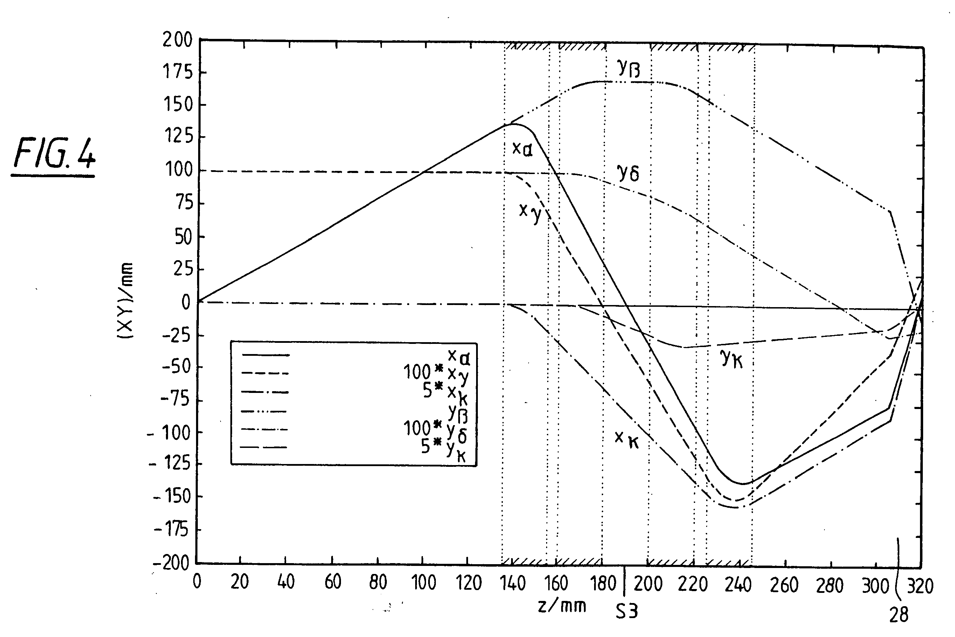

In der Figur 4 sind die Fundamentalbahnen (xα, yβ, xγ und yδ), sowie die Dispersion (xκ) in x-Richtung und yκ in y-Richtung für den vorstehend beschriebenen Monochromator dargestellt. Die Fundamentalbahnen sind dabei in der sogenannten SCOFF-Näherung (Sharp Cut-Off Fringing Field) berechnet. Für alle vier Wienfilter (W1 ― W4) wurde dabei eine effektive Feldlänge von 20mm und für die Abstände jeweils zwischen den äußeren Wienfiltern und dem benachbarten inneren Wienfilter ein Abstand von 5mm und für den Abstand zwischen den beiden mittleren Wienfiltern (W2, W3) ein Abstand von 20mm zugrunde gelegt. Wie der Figur 4 entnehmbar ist, ist die Fundamentalbahn (xα) antisymmetrisch zur Mittelebene (S3) und die Fundamentalbahn (yβ) symmetrisch zur Mittelebene (S3).

Aufgrund der entsprechend gewählten Polarität der einzelnen Wienfilter derart, daß die Polarität der gekreuzten Felder im ersten Wienfilter (W1) und im vierten Wienfilter (W4) identisch ist, demhingegen die Polarität der gekreuzten Felder in den beiden mittleren Wienfiltern (W2, und W3) entgegengesetzt zueinander ist, ist der Monochromator als Ganzes und in beiden Schnitten dispersionsfrei. In der Mittelebene (F3) hingegen liegt eine nutzbare Dispersion in x-Richtung (xκ) und zusätzlich eine nicht nutzbare Dispersion in y-Richtung (yκ) vor. Die nutzbare Dispersion (xκ) in x-Richtung überwiegt dabei die nicht nutzbare Dispersion in y-Richtung (yκ) (siehe Figur 4). Die Dispersion in y-Richtung (yκ) ist nicht nutzbar, da der Energieselektionsspalt aufgrund des astigmatischen Zwischenbildes parallel zur astigmatischen Zwischenbildlinie ausgerichtet werden muß. Aufgrund der Dispersion (yκ) auch in y-Richtung sind die in der Mittelebene (S3) entstehenden Strichbilder je nach Energie der Teilchen in y-Richtung, also in Strichrichtung, zueinander versetzt. Dieses ist jedoch nicht störend, wenn die Spaltlänge der Spaltblende hinreichend groß gewählt ist oder die Strichbilder für unterschiedliche Energien in Spaltrichtung versetzt in der Schlitzblende liegen.

Aus der Dispersion (xκ) in x-Richtung von 16,4 mm für ein 10 keV Elektron ergibt sich eine Dispersion von etwa 1,6µm pro eV in der Mittelebene (S3), was für ein 10 keV Elektron relativ groß ist. Um die Energiebreite auf 0,2eV zu reduzieren, ist eine Spaltbreite von 320 nm erforderlich. Derartige Spaltbreiten sind mikro-mechanisch leicht herstellbar. Für Elektronen mit einer niedrigeren Energie als 10 keV ist die Dispersion entsprechend höher und entsprechend größere Spaltbreiten sind zum Erreichen gleicher Energiebreiten ausreichend.

Aufgrund des astigmatischen Zwischenbildes und keiner weiteren reellen Zwischenbilder im Monochromator ist kein relevanter Boerscheffekt im Monochromator zu erwarten.

Der Monochromator kann im übrigen auch so betrieben werden, daß der Gegenstandspunkt (P1) und der dazu konjugierte Bildpunkt (P2) virtuell und stigmatisch im Monochromator liegen.

Aufgrund der beschriebenen Symmetrien bzw. Anti-Symmetrien von Feldern und axialen Fundamentalbahnen ist der Monochromator als Ganzes frei von Öffnungsfehlern zweiter Ordnung. Der Öffnungsfehler zweiter Ordnung in x-Richtung in der Energieselektionsebene, also in der Mittelebene, kann bei Bedarf mit Hilfe zweiter Hexapole oder entsprechenden Hexapolanteilen der Wienfilter korrigiert werden. Entsprechende Hexapole (H1, H2) sind in den Figuren 3a und 3b angedeutet. Um die Symmetrie des Gesamtsystemes zu erhalten, sind diese Hexapole natürlich ebenfalls symmetrisch zur Mittelebene (S3) anzuordnen.

Die Randfeldblenden zwischen den Wienfiltern (23, 27) (Figur 2) sind als Lochblenden ausgebildet und liegen auf Masse bzw. auf dem Mittelwert der Elektrodenpotentiale (Strahlpotential) der elektrostatischen Dipole der beiden benachbarten Wienfilter. Diese Randfeldblenden sollten aus einem Material hoher magnetischer Permeabilität und geringer Remanenz bestehen.

Die vier Einzelelemente des erfindungsgemäßen Korrektors sind relativ einfach herstellbar. Es werden keine Quadrupollinsen oder dispersive elektronen-optische Prismen mit Quadrupolanteilen benötigt. Die optische Achse bleibt gerade und der Monochromator kann deshalb auch sehr einfach in ausgeschaltetem Zustand betrieben werden.

Da in den vier Wienfiltern nur gekreuzte einfache Dipolfelder (also ohne Quadrupolanteil) erzeugt werden, ist die Justierung dieser vier Wienfilter gegeneinander und des gesamten Monochromators zu den Linsen des Elektronenmikroskopes unempfindlich und einfach zu bewerkstelligen.

Anzumerken ist bezüglich der Figur 4 noch, daß bei der Simulation und Berechnung der Fundamentalstrahlen davon ausgegangen wurde, daß an der mit (28) bezeichneten Stelle die Hauptebene des dem Monochromator nachfolgenden Objektivs oder Kondensors angeordnet ist. Die Brechung der Fundamentalstrahlen an dieser Stelle erfolgt nicht durch den Monochromator sondern durch die Objektiv- bzw. Kondensorlinse. Ohne Objektiv- oder Kondensorlinse an der mit (28) bezeichneten Stelle würden die Fundamentalstrahlen sich geradlinig fortsetzen, woraus sich dann die oben beschriebenen Symmetrie-Eigenschaften und die Dispersionsfreiheit ergeben. Die Dispersionsfreiheit und auch die aus den Symmetrieeigenschaften resultierenden Vorteile bleiben natürlich auch unter Einsatz der Objektiv- oder Kondensorlinse erhalten.

## Patentansprüche

1. Monochromator für geladene Teilchen mit mehreren seriell hintereinander in Ausbreitungsrichtung der Teilchen angeordneten Wienfiltern (W1 - W4), **dadurch gekennzeichnet, dass** die Wienfilter teilweise azimutal um die optische Achse um 90° gegenüber den anderen Wienfiltern verdreht angeordnet sind.

2. Monochromator nach Anspruch 1, wobei mindestens vier Wienfilter vorgesehen sind, von denen zwei azimutal um 90° gegenüber den beiden anderen Wienfiltern verdreht sind.

3. Monochromator nach Anspruch 1 oder 2, wobei die beiden inneren Wienfilter anti-parallel zueinander angeordnet sind.

4. Monochromator nach einem der Ansprüche 1-3, wobei die beiden inneren Wienfilter weiter voneinander beabstandet sind als die jeweils äußeren Wienfilter von den beiden inneren Wienfiltern.

5. Monochromator nach einem der Ansprüche 1-4, wobei die Wienfilter (W1-W4) so erregt sind, daß sie eine astigmatische Abbildung in einer Mittelebene (S3) bewirken.

6. Monochromator nach einem der Ansprüche 1-5, wobei die Brechkraft der äußeren Wienfilter (W1, W4) größer als die Brechkraft der beiden mittleren Wienfilter (W2, W3) ist und das Wienfilter insgesamt stigmatisch abbildet.

7. Monochromator nach einem der Ansprüche 1 - 6, wobei zwischen den Wienfiltern (W1, W2, W3, W4) Blenden (23, 27) aus magnetisch hochpermeablem und elektrisch leitfähigem Material vorgesehen sind.

8. Monochromator für geladene Teilchen mit einem oder mehreren seriell hintereinander in Ausbreitungsrichtung der Teilchen angeordneten Wienfilter(n), **dadurch gekennzeichnet, dass** die Polschuhe (13, 15) der magnetischen Dipole des Wienfilters und die Elektroden (14, 16) der elektrischen Dipole des Wienfilters bezüglich einer Azimutaldrehung um 90° symmetrisch zueinander ausgebildet sind.

9. Monochromator nach Anspruch 8, wobei sowohl die magnetischen Polschuhe (13, 15) der magnetischen Dipole als auch die Elektroden (14, 16) der elektrischen Dipole aus weichmagnetischem Material bestehen.

10. Monochromator nach Anspruch 9, wobei elektrische Isolierungen (9, 10, 11, 12) zwischen den Polschuhen jedes einzelnen Wienfilters vorgesehen sind.

11. Monochromator nach einem der Ansprüche 8 - 10, wobei die einander zugerichteten Flächen der Polschuhe und Elektroden der Wienfilter als konzentrische Kugelflächenabschnitte oder koaxiale Zylinderflächenausschnitte ausgebildet sind.

12. Monochromator nach einem der Ansprüche 8 - 11, wobei vier Wienfilter (W1 - W4) koaxial zu einer optischen Achse (OA) angeordnet sind und die beiden mittleren Wienfilter (W2, W3) um die optische Achse azimutal betragsmäßig um 90° verdreht gegenüber den beiden äußeren Wienfiltern (W1, W4) orientiert sind.

13. Monochromator nach einem der Ansprüche 8 bis 12, wobei Magnetspulen (13s, 14s, 15s, 16s) und elektrische Kontaktierungen derart vorgesehen sind, daß die Feldrichtungen der magnetischen und elektrischen Dipole durch Wahl der Ansteuerungen in 90°-Schritten um die optische Achse (OA) drehbar sind.

## Claims

1. Monochromator for charged particles with a plurality of Wien filters (W1-W4) which are arranged in series one after the other in the propagation direction of the particles, **characterized in that** the Wien filters are arranged such that they are in part azimuthally rotated about the optical axis by 90° relative to the other Wien filters.

2. Monochromator according to Claim 1, wherein at least four Wien filters are provided, of which two are azimuthally rotated by 90° relative to the other Wien filters.

3. Monochromator according to either Claim 1 or 2, wherein the two inner Wien filters are arranged in a mutually anti-parallel manner.

4. Monochromator according to one of Claims 1-3, wherein the spacing between the two inner Wien filters is larger than that of the respectively outer Wien filters from the two inner Wien filters.

5. Monochromator according to one of Claims 1-4, wherein the Wien filters (W1-W4) are excited such that they effect an astigmatic image in a central plane (S3).

6. Monochromator according to one of Claims 1-5, wherein the refractive power of the outer Wien filters (W1, W4) is larger than the refractive power of the two middle Wien filters (W2, W3) and the Wien filter overall images stigmatically.

7. Monochromator according to one of Claims 1-6, wherein stops (23, 27) composed of magnetically highly permeable and electrically conductive material are provided between the Wien filters (W1, W2,W3, W4).

8. Monochromator for charged particles with one or a plurality of Wien filter(s) which are arranged in series one after the other in the propagation direction of the particles, **characterized in that** the pole shoes (13, 15) of the magnetic dipole of the Wien filter and the electrodes (14, 16) of the electric dipoles of the Wien filter are designed symmetrically with respect to each other relative to an azimuthal rotation by 90°.

9. Monochromator according to Claim 8, wherein both the magnetic pole shoes (13, 15) of the magnetic dipoles and the electrodes (14, 16) of the electric dipoles are composed of a magnetically soft material.

10. Monochromator according to Claim 9, wherein electric insulations (9, 10, 11, 12) are provided between the pole shoes of each individual Wien filter.

11. Monochromator according to one of Claims 8-10, wherein those surfaces of the pole shoes and electrodes of the Wien filters which face each other are in the form of concentric spherical-surface sections or coaxial cylindrical-surface sections.

12. Monochromator according to one of Claims 8-11, wherein four Wien filters (W1-W4) are arranged coaxially to an optical axis (OA) and the two middle Wien filters (W2, W3) are oriented such that they are azimuthally rotated about the optical axis by 90° in terms of magnitude relative to the two outer Wien filters (W1, W4).

13. Monochromator according to one of Claims 8 to 12, wherein solenoids (13s, 14s, 15s, 16s) and electric contact-connections are provided such that the field directions of the magnetic and electric dipoles can be rotated about the optical axis (OA) in 90° steps by means of the choice of actuations.

## Revendications

1. Monochromateur pour particules chargées qui présente plusieurs filtres de Wien (W1-W4) disposés en série les uns derrière les autres dans la direction de propagation des particules, **caractérisé en ce que** certains des filtres de Wien sont décalés azimutalement de 90° autour de l'axe optique par rapport aux autres filtres de Wien.

2. Monochromateur selon la revendication 1, dans lequel au moins quatre filtres de Wien sont prévus, parmi lesquels deux sont décalés azimutalement de 90° par rapport aux deux autres filtres de Wien.

3. Monochromateur selon les revendications 1 ou 2, dans lequel les deux filtres de Wien intérieurs sont disposés en position mutuellement antiparallèle l'un par rapport à l'autre.

4. Monochromateur selon l'une des revendications 1 à 3, dans lequel les deux filtres de Wien intérieurs sont plus éloignés l'un de l'autre que les filtres de Wien extérieurs le sont par rapport aux deux filtres de Wien intérieurs.

5. Monochromateur selon l'une des revendications 1 à 4, dans lequel les filtres de Wien (W1-W4) sont excités de manière à former une image astigmatique dans un plan central (S3).

6. Monochromateur selon l'une des revendications 1 à 5, dans lequel l'indice de réfraction des filtres de Wien extérieurs (W1, W4) est supérieur à l'indice de réfraction des deux filtres de Wien intérieurs (W2, W3), le filtre de Wien étant globalement stigmatique.

7. Monochromateur selon l'une des revendications 1 à 6, dans lequel des écrans (23, 27) en matériau à haute perméabilité magnétique et électriquement conducteur sont prévus entre les filtres de Wien (W1, W2, W3, W4).

8. Monochromateur pour particules chargées qui présente un ou plusieurs filtres de Wien disposés en série les uns derrière les autres dans la direction de propagation des particules, **caractérisé en ce que** les semelles polaires (13, 15) des dipôles magnétiques du filtre de Wien et les électrodes (14, 16) des dipôles électriques du filtre de Wien sont symétriques l'un par rapport à l'autre par rotation azimutale de 90°.

9. Monochromateur selon la revendication 8, dans lequel aussi bien les semelles polaires magnétiques (13, 15) des dipôles magnétiques que les électrodes (14, 16) desdits pôles électriques sont constituées d'un matériau magnétique doux.

10. Monochromateur selon la revendication 9, dans lequel des isolations électriques (9, 10, 11, 12) sont prévues entre les semelles polaires de chacun des filtres de Wien.

11. Monochromateur selon l'une des revendications 8 à 10, dans lequel les surfaces orientées l'une vers l'autre des semelles polaires et des électrodes des filtres de Wien sont configurées comme calottes sphériques concentriques ou segments cylindriques coaxiaux.

12. Monochromateur selon l'une des revendications 8 à 11, dans lequel quatre filtres de Wien (W1-W4) sont disposés coaxialement par rapport à un axe optique (OA) et les deux filtres de Wien centraux (W2, W3) sont tournés azimutalement autour de l'axe optique de 90° par rapport aux deux autres filtres de Wien extérieurs (W1, W4).

13. Monochromateur selon l'une des revendications 8 à 12, dans lequel des bobines magnétiques (13s, 14s, 15s, 16s) et des contacts électriques sont prévus de telle sorte que la direction du champ des dipôles magnétiques et des dipôles électriques peut être tournée autour de l'axe optique (OA) par sélection de commandes par pas de 90°.
